# EUROPEAN PATENT SPECIFICATION

(11) **EP 1 826 829 B1**
(45) Date of publication and mention of the grant of the patent: **11.04.2012**
(21) Application number: 07003433.5
(22) Date of filing: 19.02.2007
(51) Int. Cl.: H01L 31/0236, H01L 31/075, H01L 31/18

(54) **Method for fabrication of a photovoltaic device including making an irregularly surfaced substrate**
Verfahren zur Herstellung einer photovoltaischen Vorrichtung mit Verfahren zur Herstellung von Substraten mit unregelmäßiger Oberfläche
Procédé pour fabriquer un dispositif photovoltaïque avec un procédé pour fabriquer un substrat à surface irrégulière

(30) Priority: 23.02.2006 JP 2006046332; 27.06.2006 JP 2006176958
(43) Date of publication of application: 29.08.2007
(73) Proprietor: SANYO ELECTRIC CO., LTD., Moriguchi City, Osaka 570-8677 (JP)
(72) Inventor: Inoue, Hirotada, Sendai-city Miyagi 980-0871 (JP); Taguchi, Mikio, Hirakata-city Osaka 573-1124 (JP); Yoshimura, Naoki, Kobe-city Hyogo 654-0012 (JP)
(74) Representative: TER MEER - STEINMEISTER & PARTNER GbR

(56) References cited:
- JP-A- 4 338 643
- JP-A- 2004 349 379
- US-A1- 2005 196 587
- XI Z ET AL: "Investigation of texturization for monocrystalline silicon solar cells with different kinds of alkaline" RENEWABLE ENERGY, PERGAMON PRESS, OXFORD, GB LNKD- DOI:10.1016/J.RENENE.2004.03.003, vol. 29, no. 13, 1 October 2004 (2004-10-01), pages 2101-2107, XP004520159 ISSN: 0960-1481
- YANG C R ET AL: "Effects of mechanical agitation and surfactant additive on silicon anisotropic etching in alkaline KOH solution" SENSORS AND ACTUATORS A, ELSEVIER SEQUOIA S.A., LAUSANNE, CH LNKD- DOI:10.1016/J.SNA.2004.07.015, vol. 119, no. 1, 28 March 2005 (2005-03-28), pages 263-270, XP025324968 ISSN: 0924-4247 [retrieved on 2005-03-28]

## Description

### BACKGROUND OF THE INVENTION

### TECHNICAL FIELD

The present invention relates to a method for fabricating a photovoltaic device using a method of making a crystalline silicon substrate having an irregularly structured surface.

### DESCRIPTION OF RELATED ART

In solar cells, it is important that a substrate surface be roughened to reduce its reflection of light. In crystalline solar cells, a reflectance can be reduced by anisotropically etching a surface of a silicon substrate in an alkaline solution so that a pyramid-like texture structure is imparted to the surface.

Methods have been conventionally known wherein an alkaline solution containing a surfactant is used to etch a surface of a crystalline semiconductor substrate so that an irregularity, called a texture structure, is given to the surface of the substrate. In Japanese Patent Laying-Open No. 2002-57139, a crystalline semiconductor substrate is immersed in an alkaline solution containing a surfactant consisting chiefly of caprylic acid or lauric acid so that a surface of the substrate is etched to form an irregularity structure. Caprylic acid and lauric acid is unsusceptible to decomposition and thus stable at a texturizing treatment temperature (about 80 °C). This permits repeated use of the same etching solution and accordingly increases reproducibility of the texturizing treatment.

Caprylic acid and lauric acid are produced from a natural coconut oil which contains aliphatic acids having approximately from 8 to 18 carbon atoms. The respective types and contents of aliphatic acids in a typical coconut oil are specified in Table 1.

**Table 1**

| Type of Aliphatic Acid | Carbon Number | Content (%) | Boiling Point (°C) |
|---|---|---|---|
| Caproic Acid | 6 | 0.4 | 205 |
| Caprylic Acid | 8 | 7.7 | 239 |
| Capric Acid | 10 | 6.2 | 269 |
| Lauric Acid | 12 | 47 | 298 |
| Myristic Acid | 14 | 18 | 326 |
| Palmitic Acid | 16 | 9.5 | 351 |
| Stearic Acid | 18 | 2.9 | 361 |
| Oleic Acid | 18 | 6.9 | 360 |

Caprylic acid and lauric acid are obtained by distilling this coconut oil. However, such aliphatic acids are close in boiling point to each other because of a small difference in carbon number, as shown in Table 1. It is accordingly difficult to obtain perfectly pure aliphatic acids by distillation, resulting in the inclusion of aliphatic acids having unlike carbon chains as impurities.

The respective types and contents of such impurities may be consistent if the raw material used has the same composition. However, they are not consistent because the coconut oil as the raw material is a natural substance and its constituents vary in type depending on the production place and harvesting season of the raw material. Accordingly, the types and amounts of aliphatic acid impurities in the caprylic acid or lauric acid vary with every production lot, i.e., they are inconsistent.

The caprylic acid and lauric acid also contain other impurities such as alkane, ketone and aldehyde. However, their contents vary from lot to lot by the reason that the raw material is a natural substance.

A composition of a commercial caprylic acid was analyzed. The results are shown in Table 2.

**Table 2**

| | Caproic Acid | Caprylic Acid | Capric Acid | Lauric Acid | Others |
|---|---|---|---|---|---|
| Lot #1 | - | 99.4 | 0.4 | 0.2 | - |
| Lot #2 | - | 99.7 | 0.2 | - | 0.1 |
| Lot #3 | - | 99.7 | 0.2 | - | 0.1 |
| Lot #4 | - | 99.7 | 0.2 | - | 0.1 |
| Lot #5 | - | 99.7 | 0.2 | - | 0.1 |
| Lot #6 | - | 99.7 | 0.2 | - | 0.1 |
| Lot #7 | - | 99.6 | 0.4 | - | - |
| Lot #8 | 0.04 | 99.7 | 0.3 | - | - |
| Lot #9 | - | 99.9 | 0.1 | - | - |
| Lot #10 | 0.1 | 99.9 | 0 | - | - |
| Lot #11 | - | 99.9 | 0.1 | - | - |
| Lot #12 | - | 100 | - | - | - |
| Lot #13 | - | 99.5 | 0.1 | 0.3 | 0.1 |

As can be seen from Table 2, the commercial caprylic acid contains a caproic acid having 6 carbon atoms, a capric acid having 10 carbon atoms, a lauryl acid having 12 carbon number and others, with their types and contents varying from lot to lot.

The publication "investigation of texturization for monocrystalline silicon solar cells with different kinds of alkaline" by Zhenqiang Xi et al., published in Renewable Energy 29 (2004) 2101-2107 describes various alkalines used in the prior art.

It is generally known that a surfactant such as a salt of an aliphatic acid, even if added in a slight amount, acts on a substrate. Thus, in the case where an alkaline solution is used to etch a silicon substrate, if the alkaline solution contains an aliphatic acid impurity even in a slight amount, texture formation is disturbed. Accordingly, in the case where a surface of the silicon substrate is etched by an etching solution containing a caprylic acid or lauric acid, inclusion of aliphatic acids having unlike carbon numbers as impurities adversely affects a shape and a density of the texture and also alters an optimum concentration for texture formation. The variation in type and concentration of the impurities from lot to lot, which provides the aforementioned significant effects, prevents stable formation of the standard irregularity structure on the surface and, as a result, causes a cost increase and an operating efficiency reduction.

### SUMMARY OF THE INVENTION

It is an obj ect of the present invention to provide a method for fabricating a photovoltaic device using a method of making an irregularly surfaced substrate, which can reduce variation of an etching solution from lot to lot and thus stably impart a standard irregularity structure to a surface of the substrate.

The method of making an irregularly surfaced substrate, forming a part of the method according to claim 1 of the present invention, is a method wherein a crystalline silicon substrate is immersed in an alkaline solution to anisotropically etch a surface of the substrate so that an irregularity structure is imparted to the surface of the substrate. Characteristically, the alkaline solution contains an additive represented by the following general formula (1) : 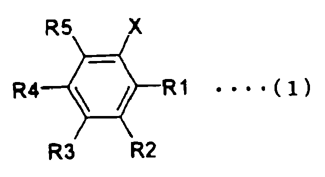 (in the formula, X is a carboxyl, sulfonic, sulfate ester, phosphate ester or quaternary ammonium group; R1 - R5 are independently a hydrogen atom or an alkyl, alkenyl or alkoxy group; and at least one of R1- R5 has 3 or more carbon atoms).

By etching a surface of a crystalline silicon substrate with the use of an alkaline solution containing the additive represented by the above general formula (1), in accordance with the present invention, the variation of an etching solution from lot to lot is reduced so that a irregularity structure which meets the standard can be stably imparted to the surface of the crystalline silicon substrate.

In the above general formula (1), X denotes a functional group capable of ionization in an alkaline solution and is any of carboxyl, sulfonic, sulfate ester, phosphate ester and quaternary ammonium whose structures are shown below: 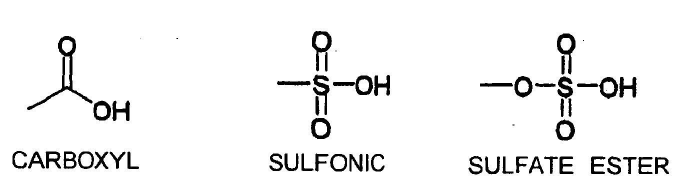 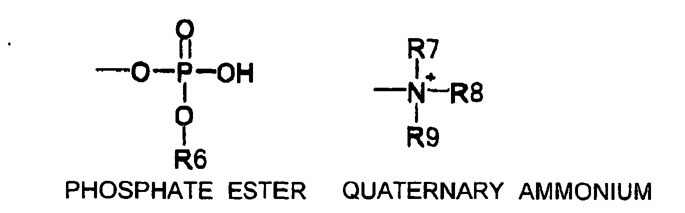 (in the formula, R6 is hydrogen or alkyl and R7, R8 and R9 are alkyl).

More preferably, R6 - R9 are independently an alkyl group having 1 - 3 carbon atoms. In the above general formula (1), preferably, any one of R1 - R5 is an alkyl, alkenyl or alkoxy group having 3 or more carbon atoms and others are independently a hydrogen atom or an alkyl, alkenyl or alkoxy group having 2 or less carbon atoms. More preferably, the alkyl, alkenyl or alkoxy group having 3 or more carbon atoms is an alkyl, alkenyl or alkoxy group having from 3 to 8 carbon atoms.

The additive represented by the formula (1), for use in the present invention, can be produced primarily by chemical synthesis using petroleum or coal as a raw material. For example, 4-propylbenzoic acid can be produced by general Friedel-Crafts alkylation, bromination and Grignard synthesis, as shown by the following reaction formulas. 1-chloropropane and benzene, as a raw material, can be both produced from petroleum or coal, and high-purity products are stably supplied. Also, in the synthesis of the additive in the present invention, various alkyls can be introduced in the benzoic acid by using any other halogenized alkane in exchange for 1-chloropropane as a starting material.

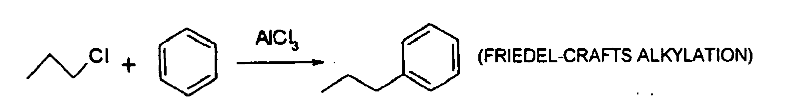

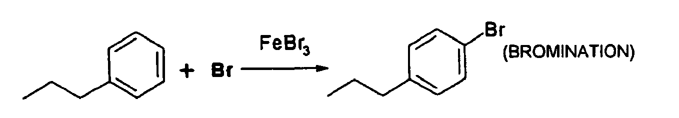

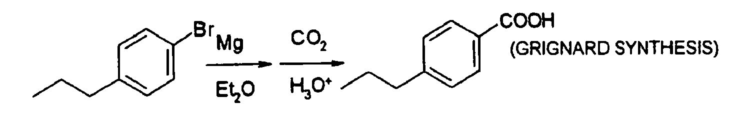

The additive for use in the present invention can be synthesized using materials derived from petroleum or coal, as described above. Accordingly, variation of impurities in a raw material from lot to lot, due to the difference of production place or harvesting season of the raw material, can be avoided.

Also, aliphatic acid impurities which tend to affect texture formation are excluded. Accordingly, the present invention can reduce the number of unusable lots during production and reduce variation of an etching solution from lot to lot.

In the present invention, a concentration of the additive in the alkaline solution is preferably within the range of 1 - 0.0001 mole/liter.

The additive, if its concentration exceeds 1 mole/liter, restrains the alkaline solution from etching a crystalline silicon substrate. This raises problems. For example, the irregularity structure is reduced in size or out of shape.

If the concentration of the additive falls below 0.0001 mole/liter, other problems arise. For example, the etch rate becomes too high to control a shape or configuration of the irregularity structure or the uniformity of the irregularity structure is reduced.

In the case of using the additive represented by the general formula (1) in which R1 - R5 contain carbon atoms with a maximum number of 3 - 4, it is more preferred that the additive is contained in the alkaline solution in the concentration within the range of 0.1 - 0.01 mole/liter.

In the case of using the additive represented by the general formula (1) in which R1 - R5 contain carbon atoms with a maximum number of 5 - 6, it is more preferred that the additive is contained in the alkaline solution in the concentration within the range of 0.1 - 0.001 mole/liter.

In the case of using the additive represented by the general formula (1) in which R1 - R5 contain carbon atoms with a maximum number of 7 - 8, it is more preferred that the additive is contained in the alkaline solution in the concentration within the range of 0.01 - 0.0001 mole/liter.

If the additive concentration in the alkaline solution is such selected depending on the type of the additive used, the desired irregularity structure can be imparted more stably and reproducibly to the surface of the crystalline silicon substrate.

Preferably, the alkaline solution for use in the present invention is an aqueous sodium hydroxide solution or an aqueous potassium hydroxide solution. In this case, its concentration is preferably within the range of 0.05 - 2.0 mole/liter, for example.

In the present invention, the crystalline silicon substrate which is etched can be illustrated by single crystal and polycrystalline silicon substrates. The single crystal silicon substrate is particularly preferred. The substrate surface to be etched preferably has a (100) plane orientation. By the choice of such plane orientation, suitable irregularity or texture structure can be given to the substrate surface.

The method of the present invention for fabricating a photovoltaic device is characterized as including the steps of making a crystalline silicon substrate having an irregularly structured surface by the above-described method of the present invention and forming a semiconductor layer on the irregularly structured surface of the crystalline silicon substrate so that the semiconductor layer forms a semiconductor junction with the crystalline silicon substrate.

In the method of the present invention for fabrication of a photovoltaic device, the irregularity structure is given to the surface of the crystalline silicon substrate according to the method of the present invention for making an irregularly surfaced substrate. Accordingly, the variation of an etching solution from lot to lot is reduced. As a result, the regular irregularity structure can be stably imparted to the substrate surface. Therefore, in accordance with the method of the present invention for fabrication of a photovoltaic device, a photovoltaic device having superior photoelectric conversion characteristics can be stably fabricated. This reduces a cost and increases an operational efficiency.

In accordance with the second step in the method of the present invention for making an irregularly surfaced substrate, the variation of an etching solution from lot to lot is reduced. As a result, the regular irregularity structure can be stably imparted to the surface of the crystalline silicon substrate.

In accordance with the method of the present invention for fabrication of a photovoltaic device, a photovoltaic device is fabricated using the crystalline silicon substrate which has imparted thereto an irregular surface structure according to the method of the present invention for making an irregularly surfaced substrate. This enables reproducible fabrication of a photovoltaic device superior in photoelectric conversion characteristics and accordingly reduces the occurrence of defective production. As a result, a photovoltaic device can be fabricated efficiently.

### BEIEF DESCRIPTION OF THE DRAWING

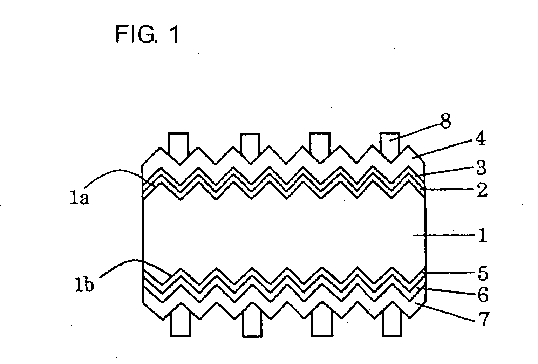

Figure 1 is a schematic sectional view which shows a photovoltaic device fabricated in an example in accordance with the present invention.

### DESCRIPTION OF THE PREFERRED EXAMPLES

The present invention is below described in more detail by way of examples which are not intended to be limiting thereof.

### EXAMPLE 1

Each additive having the structure shown below, 4-propylbenzoic acid (PrBA), 4-t-butylbenzoic acid (TBBA), 4-n-butylbenzoic acid (NBBA), 4-pentylbenzoic acid (PeBA), 4-butoxybenzoic acid (BOBA) or 4-n-octylbenzenesulfonic acid (NOBS), was added and dissolved in a 5 wt.% aqueous sodium hydroxide solution to prepare a substrate etching solution. Likewise, a comparative additive, 2-ethylbenzoic acid (EBA), was added to an aqueous sodium hydroxide solution to prepare a comparative etching solution. The concentration of each additive was adjusted to fall within the range of 1 - 0.0001 mole/liter. Specifically, the concentration was set at 0.05 mole/liter for PrBA, TBBA, NBBA, PeBA and BOBA and at 0.0004 mole/liter for NOBS.

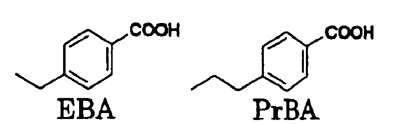

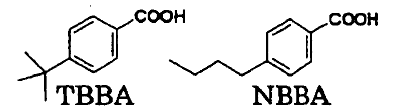

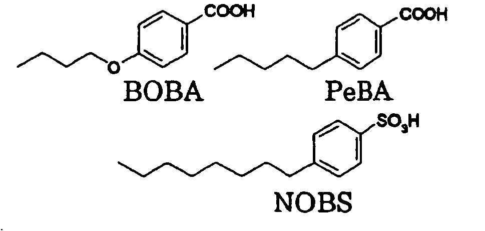

Each etching solution was elevated in temperature. An n-type single crystal silicon substrate was immersed in the etching solution at about 85 °C for about 30 minutes to etch a surface of the substrate. Etching imparted an irregularity structure to the surface. The single crystal silicon substrate was then observed by an optical microscope for its surface having the irregularity structure. Each etching solution was rated as "good" if it in the above-specified concentration range imparted a generally regular pyramid-like irregularity over an entire surface of the substrate and as "poor" if it in the above-specified concentration range imparted a configuration including relatively flat portions to the substrate surface. The evaluation results are shown in Table 3.

In Table 3, the rating ○ indicates a good result and the rating × indicates a poor result.

**Table 3**

| | Texturizing Effect |
|---|---|
| EBA | × |
| PrBA | ○ |
| TBBA | ○ |
| NBBA | ○ |
| BOBA | ○ |
| PeBA | ○ |
| NOBS | ○ |

As can be clearly seen from the results shown in Table 3, a good texture is given to the surface of the crystalline silicon substrate when the additives having an alkyl or alkoxy group having 3 or more carbon atoms, i.e., PrBA, TBBA NBBA, PeBA BOBA and NOBS, were used.

### EXAMPLE 2

4-butoxybenzoic acid (BOBA) was collected from four different lots and used to study the influence of the lot. Each lot of 4-butoxybenzoic acid was dissolved in a 5 wt.% aqueous sodium hydroxide solution to a concentration of 0.05 mole/liter to prepare an etching solution. This etching solution was heated to about 85 °C. Subsequently, an n-type single crystal silicon substrate having a (100) plane was immersed in the heated etching solution for about 30 minutes to etch a surface of the substrate.

Subsequent to etching, a reflectance of the substrate surface was measured. The measurement results are shown in Table 4. The reflectance was measured by a spectrophotometer.

The results are shown in Table 4. Also, each lot was rated as applicable if the resulting substrate surface exhibited a reflectance in the range of not exceeding 13 % and rated as inapplicable if it exhibited a reflectance outside this range.

**Table 4**

| | Reflectance (%) | Applicability |
|---|---|---|
| Lot #1 | 12.0 | Yes |
| Lot#2 | 11.9 | Yes |
| Lot #3 | 12.3 | Yes |
| Lot#4 | 11.8 | Yes |

As shown in Table 4, the substrate surfaces treated with the etching solutions of lot # 1 - lot # 4 exhibited the 11 - 12 % level of reflectance and all the substrates were found as applicable as the irregularly surfaced substrate. This demonstrates that the use of 4-butoxybenzoic acid in accordance with the present invention reduces the variation of the etching solution from lot to lot and enables more efficient production of irregularly surfaced substrates.

### COMPARATIVE EXAMPLE 1

For a comparative purpose, a caprylic acid was used to prepare an etching solution and evaluate its effect. A caprylic acid was dissolved in a 1.5 wt.% aqueous NaOH solution to a concentration of 0. 05 mole/liter to prepare an etching solution. This etching solution was heated to about 85 °C. An n-type single crystal silicon substrate was then immersed in the heated etching solution for about 30 minutes to etch a surface of the substrate.

As similar to Example 2, etching was performed using caprylic acid from 4 different lots.

Subsequent to etching, a reflectance of the substrate surface was measured as similar to Example 2. The measurement results are shown in Table 5.

**Table 5**

| | Reflectance (%) | Applicability |
|---|---|---|
| Lot #1 | 25 | No |
| Lot #2 | 23.3 | No |
| Lot #3 | 12.5 | Yes |
| Lot #4 | 17.7 | No |

As shown in Table 5, in the case where a caprylic acid is used, the reflectance of a texture structure at the substrate surface has been found to vary largely depending on the lot of caprylic acid used. As shown in Table 5, only the lot #3 among the four lots has been found to be applicable. In cases the other lots are used, the resulting substrate surface remains partly untexturized to have flat portions and exhibits a high reflectance. Accordingly, those lots have been found to be inapplicable.

In the following example, the conversion factor 10Å = 1 nm has to be taken into account.

### EXAMPLE 3

A photovoltaic device which shows good photoelectric conversion characteristics can be fabricated by imparting a texture structure to a surface of a substrate according to the above-described method of the present invention by which an irregularly surfaced substrate can be made more efficiently, and forming a semiconductor layer on the substrate so that the semiconductor layer forms a semiconductor junction with the substrate.

Figure 1 is a schematic view which shows an embodiment of a photovoltaic device as it is fabricated by the fabrication methodof the present invention. Referring to Figure 1, ann-type single crystal silicon substrate 1 having a (100) plane has a top surface 1a to which a good pyramid-like irregularity shape has been given in the fashion as described above. An intrinsic amorphous silicon thin film 2, measuring 20-200 Å thick, for example, is formed on the surface 1a. Formed on this film is a p-type amorphous silicon thin film 3, measuring 20 - 100 Å thick, for example. A transparent conducting film 4, measuring about 1, 000 Å thick and composed such as of ITO, ZnO or SnO₂ for example, is deposited on the p-type amorphous silicon thin film 3 by a sputtering technique.

Also, an intrinsic amorphous siliconthin film5, measuring 20 - 200 Å thick, for example, is formed on a bottom surface 1b of the substrate 1. Formed on this film is an n-type amorphous silicon thin film 6, measuring 20 - 200 Å thick, for example. A transparent conducting film 7, measuring about 1, 000 Å thick and composed such as of ITO, ZnO or SnO₂, for example, is deposited on the n-type amorphous silicon thin film 6 by a sputtering method. Further, a comb-shaped current collecting electrode 8 is formed on each of the top and bottom transparent conducting films 4 and 7 by a screen printing method.

The procedure of Example 2 was followed using 4-butoxybenzoic acid (BOBA) from three different lots to etch both top and bottom surfaces of a single crystal silicon substrate. The obtained silicon substrate with an irregularity structure given to its top and bottom surfaces was employed to fabricate a photovoltaic device as shown in Figure 1. The intrinsic amorphous silicon thin films 2 and 5 had a thickness of 100 Å. The p-type amorphous silicon thin film 3 had a thickness of 50 Å. The n-type amorphous silicon thin film 6 had a thickness of 200 Å. The transparent conducting films 4 and 7 were formed from ITO.

The three types of photovoltaic devices obtained in the fashion as described above were then measured for short-circuit current (Isc), open-circuit voltage (Voc), fill factor (F.F.) and conversion factor. The measurement results are shown in Table 6.

**Table 6**

| | Isc (mA/cm²) | Voc (V) | F.F. | Conversion Factor (%) |
|---|---|---|---|---|
| Lot #1 | 37.5 | 0.696 | 0.773 | 20.2 |
| Lot #2 | 37.5 | 0.702 | 0.761 | 20.0 |
| Lot #3 | 36.7 | 0.696 | 0.786 | 20.1 |

As can be seen from Table 6, the photovoltaic devices fabricated in accordance with the present invention exhibit Isc, Voc, F.F. and conversion factor each with a variation within ± 2 %, and show good photoelectric conversion characteristics without being little influenced by the particular lot used.

The method for fabrication of a photovoltaic device in accordance with the present invention is limited by the claims and is not limited to the above Examples. For example, phosphorus (P) may be thermally diffused over an irregularly structured surface of ap-type single crystal silicon substrate to deposit thereon an n-type layer which forms a semiconductor junction.

## Claims

1. A method for fabrication of a photovoltaic device including the steps of:
making a crystalline silicon substrate having an irregularly structured surface by immersing a crystalline silicon substrate in an alkaline solution to anisotropically etch a surface of the substrate so that an irregularity structure is imparted to the surface of the substrate, **characterized in that** said alkaline solution contains an additive represented by the following general formula (1): 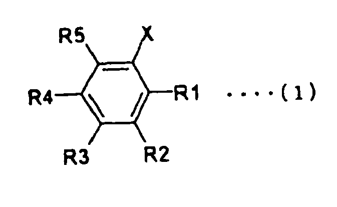 wherein X is a carboxyl, sulfonic, sulfate ester, phosphate ester or quaternary ammonium group; R1 - R5 are independently a hydrogen atom or an alkyl, alkenyl or alkoxy group; and at least one of R1 - R5 has 3 or more carbon atoms; and
forming a semiconductor layer on said irregularly structured surface of the crystalline silicon substrate so that the semiconductor layer forms a semiconductor junction with the crystalline silicon substrate.

2. The method for fabrication of a photovoltaic device as recited in claim 1, **characterized in that** any one of R1 - R5 in said general formula (1) is an alkyl, alkenyl or alkoxy group having 3 or more carbon atoms and the others are independently a hydrogen atom or an alkyl, alkenyl or alkoxy group having 2 or less carbon atoms.

3. The method for fabrication of a photovoltaic device as recited in claim 1 or 2, **characterized in that** a concentration of said additive in the alkaline solution is 1 - 0.0001 mole/liter.

4. The method for fabrication of a photovoltaic device as recited in any one of claims 1 - 3, **characterized in that** said alkaline solution is an aqueous sodium hydroxide solution or an aqueous potassium hydroxide solution.

## Patentansprüche

1. Verfahren zur Herstellung einer Photovoltaikvorrichtung, beinhaltend die Schritte:
Herstellen eines kristallinen Siliziumsubstrats mit einer unregelmäßig strukturierten Oberfläche durch Eintauchen eines kristallinen Siliziumsubstrats in eine alkalische Lösung, um eine Substratoberfläche anisotropisch zu ätzen, so dass eine unregelmäßige Oberfläche auf die Substratoberfläche aufgebracht wird, **dadurch gekennzeichnet, dass** die alkalische Lösung ein Additiv enthält, dargestellt durch die folgende allgemeine Formel (1): 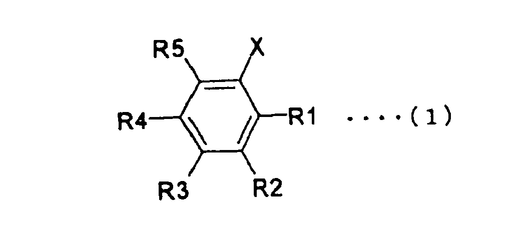 wobei X eine Carboxyl-, Sulfon-, Sulfatester-, Phosphatester- oder quaternäre Ammoniumgruppe ist, R1 bis R5 unabhängig ein Wasserstoffatom oder eine Alkyl-, Alkenyl- oder Alkoxygruppe sind und wenigstens eines von R1 bis R5 drei oder mehr Kohlenstoffatome aufweist, und
Ausbilden einer Halbleiterschicht auf der unregelmäßig strukturierten Oberfläche des kristallinen Siliziumsubstrats, so dass die Halbleiterschicht eine halbleitende Kontaktstelle mit dem kristallinen Siliziumsubstrat bildet.

2. Verfahren zur Herstellung einer Photovoltaikvorrichtung gemäß Anspruch 1, **dadurch gekennzeichnet, dass** irgendeines von R1 bis R5 in der allgemeinen Formel (1) eine Alkyl-, Alkenyl- oder Alkoxygruppe mir drei oder mehr Kohlenstoffatomen ist und die anderen unabhängig ein Wasserstoffatom oder eine Alkyl-, Alkenyl- oder Alkoxygruppe mit zwei oder weniger Kohlenstoffatomen sind.

3. Verfahren zur Herstellung einer Photovoltaikvorrichtung gemäß Anspruch 1 oder 2, **dadurch gekennzeichnet, dass** eine Konzentration des Additivs in der alkalischen Lösung 1 - 0,0001 Mol/Liter beträgt.

4. Verfahren zur Herstellung einer Photovoltaikvorrichtung gemäß irgendeinem der Ansprüche 1 bis 3, **dadurch gekennzeichnet, dass** die alkalische Lösung eine wässrige Natriumhydroxidlösung oder eine wässrige Kaliumhydroxidlösung ist.

## Revendications

1. Procédé de fabrication d'un dispositif photovoltaïque, lequel procédé comporte les étapes suivantes :
- préparer un substrat en silicium cristallin qui présente une surface de structure irrégulière, en plongeant un substrat en silicium cristallin dans une solution alcaline de manière à ce qu'une surface du substrat soit attaquée de manière anisotrope et qu'il se forme ainsi des irrégularités de structure sur cette surface du substrat,
le procédé étant **caractérisé en ce que** ladite solution alcaline contient un adjuvant de formule générale (1) suivante : 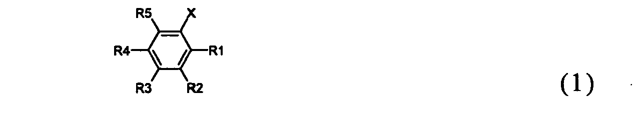 dans laquelle X représente un groupe carboxyle, sulfo, ester sulfate, ester phosphate ou ammonium quaternaire, et les symboles R1 à R5 représentent chacun, indépendamment, un atome d'hydrogène ou un groupe alkyle, alcényle ou alcoxy, étant entendu qu'au moins l'un de ces groupes symbolisés par R1 à R5 comporte 3 atomes de carbone ou plus ;
- et former une couche de semi-conducteur sur ladite surface de structure irrégulière du substrat en silicium cristallin, de manière à ce que cette couche de semi-conducteur forme avec le substrat en silicium cristallin une jonction de semi-conducteurs.

2. Procédé de fabrication d'un dispositif photovoltaïque, conforme à la revendication 1, **caractérisé en ce que**, dans ladite formule générale (1), l'un quelconque des symboles R1 à R5 représente un groupe alkyle, alcényle ou alcoxy comportant 3 atomes de carbone ou plus, et les autres symboles représentent chacun, indépendamment, un atome d'hydrogène ou un groupe alkyle, alcényle ou alcoxy comportant au plus 2 atomes de carbone.

3. Procédé de fabrication d'un dispositif photovoltaïque, conforme à la revendication 1 ou 2, **caractérisé en ce que** la concentration dudit adjuvant dans la solution alcaline vaut de 1 à 0,0001 mole par litre.

4. Procédé de fabrication d'un dispositif photovoltaïque, conforme à l'une des revendications 1 à 3, **caractérisé en ce que** ladite solution alcaline est une solution aqueuse d'hydroxyde de sodium ou une solution aqueuse d'hydroxyde de potassium.
